# EUROPEAN PATENT APPLICATION

(11) **EP 2 211 331 A1**
(43) Date of publication of application: **28.07.2010**
(21) Application number: 09252765.4
(22) Date of filing: 10.12.2009
(51) Int. Cl.: G09G 3/36, G09G 3/00

(54) **Semiconductor integrated circuit, liquid crystal driver circuit, and liquid crystal display apparatus**

(30) Priority: 21.01.2009 JP 2009011153
(71) Applicant: Sony Corporation, Tokyo 108-0075 (JP)
(72) Inventor: Hyoudou, Kenji , Sony Semiconductor Kyushu Corp., Fukuoka-Shi, Fukuoka (JP); Ichirizuka, Tak , Sony Semiconductor Kyushu Corp., Fukuoka-Shi, Fukuoka (JP); Kimoto, Takuya , Sony Semiconductor Kyushu Corp., Fukuoka-Shi, Fukuoka (JP); Togo, Minoru , Sony Semiconductor Kyushu Corp., Fukuoka-Shi, Fukuoka (JP)
(74) Representative: Robinson, Nigel Alexander Julian

(57) **Abstract**

A semiconductor integrated circuit is disclosed which includes: a first D/A converter; a second D/A converter; an amplifier configured to amplify an output of the first D/A converter; an operational amplifier configured to input an output of the second D/A converter; and a selector configured to effect switchover between a normal mode and a test mode, the normal mode being a mode in which the operational amplifier is caused to function as an amplifier for amplifying the output of the second D/A converter, the test mode being a mode in which the operational amplifier is caused to function as a comparator for comparing the output of the second D/A converter with the output of the first D/A converter.

## Description

The present invention relates to a semiconductor integrated circuit, a liquid crystal driver circuit, and a liquid crystal display apparatus equipped with digital-to-analog (D/A) converters and amplifiers for amplifying the outputs of the D/A converters.

Some semiconductor integrated circuits have each been known to be furnished with a plurality of D/A converters and a plurality of amplifiers for amplifying the outputs of these D/A converters. An example of this type of semiconductor integrated circuit is a liquid crystal driver circuit that outputs drive signals for driving the pixels arrayed on a liquid crystal panel.

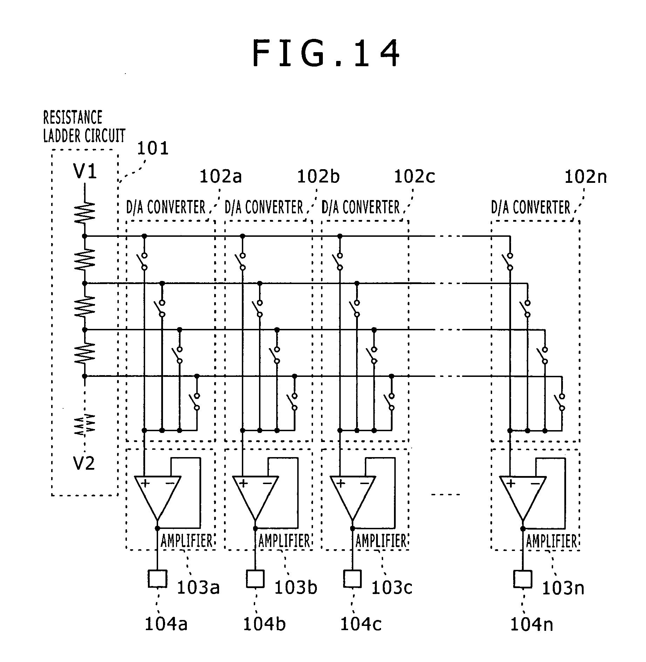

As shown in FIG. 14, the above type of semiconductor integrated circuit includes a resistance ladder circuit 101 for generating a plurality of reference voltages, a plurality of D/A converters 102a through 102n, and amplifiers 103a through 103n for amplifying the outputs of the D/A converters 102a through 102n.

Each of the D/A converters 102a through 102n is made up of a plurality of switches. Given an externally input digital signal (called the input digital signal hereunder), each D/A converter has one of its switches selected so as to output a voltage corresponding to the input digital signal.

Each of the amplifiers 103a through 103n is composed of an operational amplifier functioning as a voltage follower. That is, an inverting input node of the operational amplifier is connected to its output node so that an analog signal input to a noninverting input node of the operational amplifier will be current-amplified for output.

The above type of semiconductor integrated circuit (also called the device hereunder) is tested upon manufacture for compliance with specifications. The test involves inputting a predetermined digital signal to the device to activate its D/A converters 102a through 102n in order to determine whether or not a predetermined analog voltage is output from the amplifiers 103a through 103n.

Such compliance testing entails attaching test probes to all output nodes 104a through 104n to see if the predetermined analog voltage is normally output. That means the larger the number of output nodes, the larger still the number of the test probes required. Since there is a limit to the maximum number of test probes that can be used in testing with semiconductor testing equipment, a growing number of output nodes translate into a diminishing number of devices that may be tested in a single testing pass. The result is an inordinate rise in the cost of testing.

One solution to the above problem involves, as shown in FIG. 15 in which is proposed by Japanese Patent Laid-open No. 2006-279132 (Patent Document 1), setting up a comparator 105 for comparing the outputs of two D/A converters. With the output voltage from each D/A converter varied, the voltage output by the comparator 105 is detected to see if each D/A converter functions normally.

One disadvantage of the technique disclosed by the above-cited Patent Document 1 is the need for separate comparators 105. This leads to an enlarged packaging area of the semiconductor integrated circuit and a jump in its manufacturing cost.

The present invention has been made in view of the above circumstances and provides a semiconductor integrated circuit, a liquid crystal driver circuit, and a liquid crystal display apparatus designed to reduce testing costs while curbing the increase in the packaging area of the device.

In carrying out the present invention and according to one embodiment thereof, there is provided a semiconductor integrated circuit including: a first D/A converter; a second D/A converter; an amplifier configured to amplify an output of the first D/A converter; and an operational amplifier configured to input an output of the second D/A converter. The semiconductor integrated circuit further includes a selector configured to effect switchover between a normal mode and a test mode, the normal mode being a mode in which the operational amplifier is caused to function as an amplifier for amplifying the output of the second D/A converter, the test mode being a mode in which the operational amplifier is caused to function as a comparator for comparing the output of the second D/A converter with the output of the first D/A converter.

Preferably, the semiconductor integrated circuit may further include a second selector configured to effect switchover between a first test mode and a second test mode when the test mode is in effect. The first test mode is a mode in which the output of the first D/A converter is input to a noninverting input node of the operational amplifier and the output of the second D/A converter is input to an inverting input node of the operational amplifier. The second test mode is a mode in which the output of the second D/A converter is input to the noninverting input node of the operational amplifier and the output of the first D/A converter is input to the inverting input node of the operational amplifier.

Preferably, the semiconductor integrated circuit may further include: n units of the first D/A converter, n being an integer of at least two; n units of the second D/A converter; n units of the amplifier configured to amplify the output of each unit of the first D/A converter; n units of the operational amplifier configured to input the output of each unit of the second D/A converter; and n units of the selector.

Preferably, the semiconductor integrated circuit may further include a logic circuit configured to output a signal indicative of normal detection when all outputs of the n operational amplifiers are either High or Low, and to output a signal indicative of fault detection when the output of at least one of the n operational amplifiers is either Low or High.

According to another embodiment of the present invention, there is provided a liquid crystal driver circuit including: n first D/A converters, n being an integer of at least two; n second D/A converters; n amplifiers each configured to amplify an output of each of the first D/A converters to supply the amplified output to a liquid crystal panel; and n operational amplifiers each configured to input an output of each of the second D/A converters. The liquid crystal driver further includes n selectors configured to effect switchover between a normal mode and a test mode, the normal mode being a mode in which the operational amplifiers are caused to function as amplifiers for amplifying the outputs of the second D/A converters, the test mode being a mode in which the operational amplifiers are caused to function as comparators for comparing the outputs of the second D/A converters with the outputs of the first D/A converters.

According to a further embodiment of the present invention, there is provided a liquid crystal display apparatus including: a liquid crystal panel; and a liquid crystal driver circuit configured to output drive signals for driving pixels furnished on the liquid crystal panel. The liquid crystal driver circuit includes: n first D/A converters, n being an integer of at least two; n second D/A converters; n amplifiers each configured to amplify an output of each of the first D/A converters to supply the amplified output to a liquid crystal panel; and n operational amplifiers each configured to input an output of each of the second D/A converters. The liquid crystal driver circuit further includes n selectors configured to effect switchover between a normal mode and a test mode, the normal mode being a mode in which the operational amplifiers are caused to function as amplifiers for amplifying the outputs of the second D/A converters, the test mode being a mode in which the operational amplifiers are caused to function as comparators for comparing the outputs of the second D/A converters with the outputs of the first D/A converters.

According to the present invention, it is thus possible to reduce the number of probes to be attached to output nodes upon device testing while curbing the packaging area of each device, whereby the number of the devices that can be tested simultaneously is increased. This helps reduce the time required for testing per device and save the cost of testing.

Embodiments of the invention will now be described, by way of example only, with reference to the accompanying drawings in which:
FIG. 1 is a schematic view showing a structure of a semiconductor integrated circuit embodying one example of the present invention;
FIGS. 2A and 2B are schematic views explanatory of how the semiconductor integrated circuit embodying one example of the present invention operates;
FIG. 3 is a schematic view showing a structure of another semiconductor integrated circuit embodying one example of the present invention;
FIG. 4 is a schematic view showing a structure of a liquid crystal display apparatus equipped with a liquid crystal driver circuit embodying one example of the present invention;
FIG. 5 is a schematic view showing a structure of the liquid crystal driver circuit shown in FIG. 4;
FIG. 6 is a schematic view showing another structure of the liquid crystal driver circuit shown in FIG. 4;
FIG. 7 is a schematic view showing a further structure of the liquid crystal driver circuit shown in FIG. 4;
FIG. 8 is a schematic view explanatory of an operation mode of the liquid crystal driver circuit shown in FIG. 4;
FIGS. 9A and 9B are schematic views explanatory of other operation modes of the liquid crystal driver circuit shown in FIG. 4;
FIG. 10 is a tabular view explanatory of the operation modes of the liquid crystal driver circuit shown in FIG. 4;
FIG. 11 is another tabular view explanatory of the operation modes of the liquid crystal driver circuit shown in FIG. 4;
FIG. 12 is a schematic view explanatory of an operation mode of another liquid crystal driver circuit;
FIG. 13 is a schematic view explanatory of an operation mode of a further liquid crystal driver circuit;
FIG. 14 is a schematic view showing a structure of an ordinary semiconductor integrated circuit equipped with D/A converters and amplifiers; and

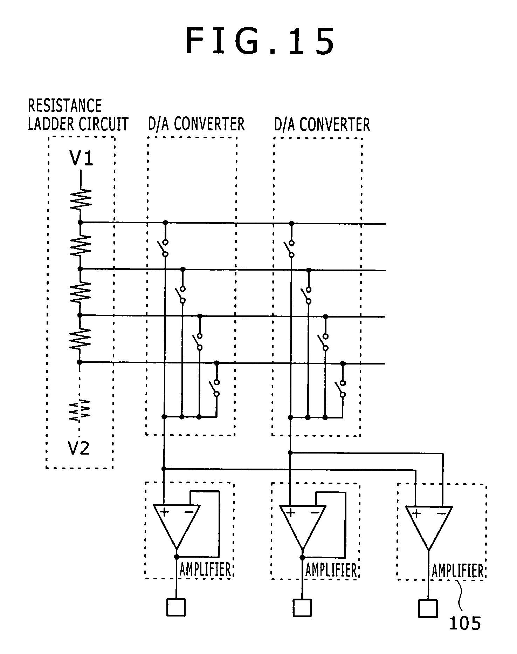

FIG. 15 is a schematic view showing a structure of another ordinary semiconductor integrated circuit equipped with D/A converters and amplifiers.

The preferred example embodiments of the present invention will now be described. The description will be made under the following headings:
1. Overview of the semiconductor integrated circuit
2. Structures and operations of the liquid crystal driver circuit and of the liquid crystal display apparatus equipped therewith
3. Other embodiments

### [1. Overview of the semiconductor integrated circuit]

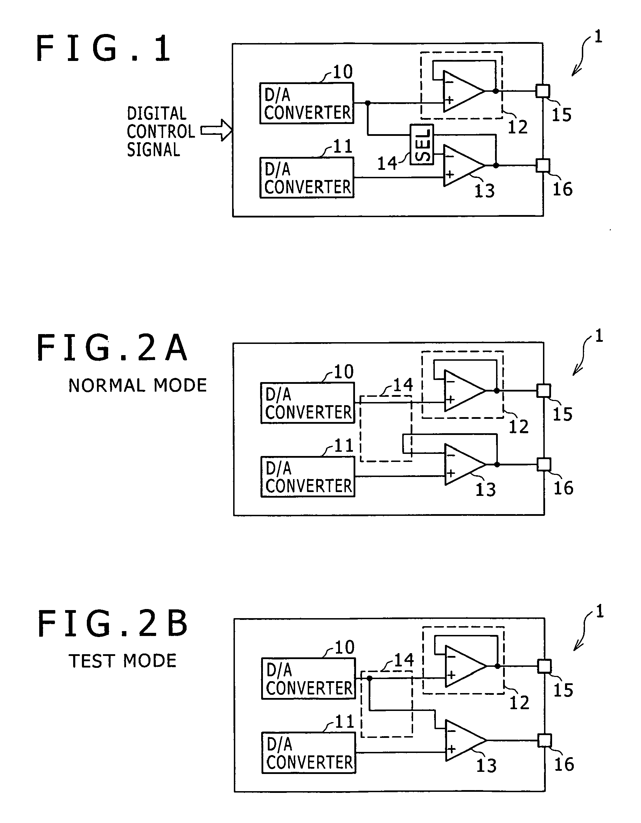

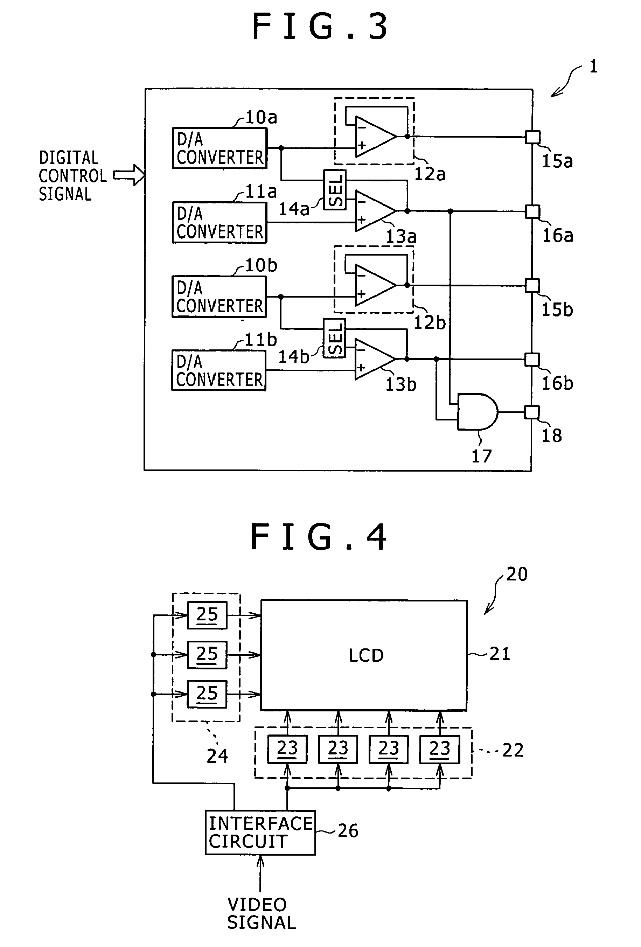

The semiconductor integrated circuit embodying one example of the present invention will now be explained in specific terms by referring to the accompanying drawings. FIGS. 1 and 3 show structures of the semiconductor integrated circuit as an example embodiment of the present invention, and FIGS. 2A and 2B are explanatory of the workings of the inventive semiconductor integrated circuit.

As shown FIG. 1, a semiconductor integrated circuit 1 embodying one example of the present invention includes a first D/A converter 10, a second D/A converter 11, an amplifier 12 for amplifying the output of the first D/A converter 10, and an operational amplifier 13 for inputting the output of the second D/A converter 11.

The first and the second D/A converters 10 and 11 each output an analog signal of a voltage value based on an externally input digital control signal. Each of the D/A converters 10 and 11 has a plurality of switches each connected to a different voltage. These switches are controlled on the basis of the digital control signal, whereby the analog signal of the voltage value reflecting the digital control signal is output.

The amplifier 12 is composed of an operational amplifier. A noninverting input node of the operational amplifier is used as the input, and an inverting input node of the operational amplifier is connected to its output node. This structure constitutes a voltage follower.

The semiconductor integrated circuit 1 further includes a selector 14 that effects switchover between a normal mode and a test mode. The normal mode is a mode in which the operational amplifier 13 is made to function as an amplifier, and the test mode is a mode in which the operational amplifier 13 is caused to function as a comparator.

In the normal mode, the operational amplifier 13 current-amplifies the output of the second D/A converter 11 and outputs what has been current-amplified through an output node 16. In the test mode, the operational amplifier 13 compares the output of the second D/A converter 11 with the output of the first D/A converter 10.

More specifically, in the normal mode, the noninverting input node of the operational amplifier 13 is used as the input and the inverting input node of the operational amplifier 13 is connected to its output node as shown in FIG. 2A. This structure constitutes a voltage follower. In the test mode, the output of the first D/A converter 10 is input to the inverting input node of the operational amplifier 13 and the output of the second D/A converter 11 is input to the noninverting input node of the operational amplifier 13 as shown in FIG. 2B.

As described, the operational amplifier 13 is made to function as an amplifier in the normal mode and as a comparator in the test mode. That means there is no need for separately provided comparators, so that any increase in the packaging area of each device can be minimized.

In the test mode, the voltage output from the first D/A converter 10 is set to be lower than the voltage output from the second D/A converter 11. With this voltage relationship maintained, the voltages output from the first and the second D/A converters 10 and 11 are gradually raised. At this time, the output of the operational amplifier 13 is High (i.e., at high potential level) if each of the D/A converters 10 and 11 is normal and Low (at low potential level) if any one of the converters is faulty. Thus by detecting the output of the operational amplifier 13 at the output node 16, it is possible to check whether each of the D/A converters 10 and 11 is normal.

If the first D/A converter 10 is faulty and its voltage is fixed to a minimum voltage level, then that voltage is always lower than the output of the second D/A converter 11. The same also holds when the second D/A converter 11 is faulty and its voltage is fixed to a maximum voltage level. Thus it might happen that failure is not detected in any of the D/A converters 10 and 11 as long as the D/A converters 10 and 11 are left outputting their voltages as outlined above.

The bottleneck above is circumvented by setting the voltage output from the first D/A converter 10 to be higher than the voltage output from the second D/A converter 11 after the test and, with this voltage relationship maintained, by gradually raising the voltages output from the first and the second D/A converters 10 and 11. At this time, the output of the operational amplifier 13 is Low if each of the D/A converters 10 and 11 is normal, and High if any one of the D/A converters is faulty. In combination with the above test, detection of the potential level at the output node 16 makes it possible to check whether each of the D/A converters 10 and 11 is normal.

As shown in FIG. 3, there may be provided a plurality of first D/A converters 10a and 10b, a plurality of second D/A converters 11a and 11b, a plurality of amplifiers 12a and 12b, a plurality of operational amplifiers 13a and 13b, and a plurality of selectors 14a and 14b. In this case, outputs in the test mode can be made common. Specifically, the outputs of the second D/A converters 11a and 11b are input to an AND circuit 17, and the output of the AND circuit 17 is connected to an output node 18.

The output from the output node 18 is High if each of the operational amplifiers 13a and 13b is normal, and Low if any one of the operational amplifiers is faulty. When a single node is used to determine whether the D/A converters 10 and 11 are normal as described above, it is possible significantly to reduce the number of the probes necessary for testing the semiconductor integrated circuit 1. That in turn translates into diminished costs of testing.

Each operational amplifier above may illustratively be a differential amplifier circuit with a high net gain, activated by the difference in potential between two inputs. The operational amplifier may thus have any circuit structure as long as it offers equivalent functionality. The same holds for the description that follows.

### [2. Structures and operations of the liquid crystal driver circuit and of the liquid crystal display apparatus equipped therewith]

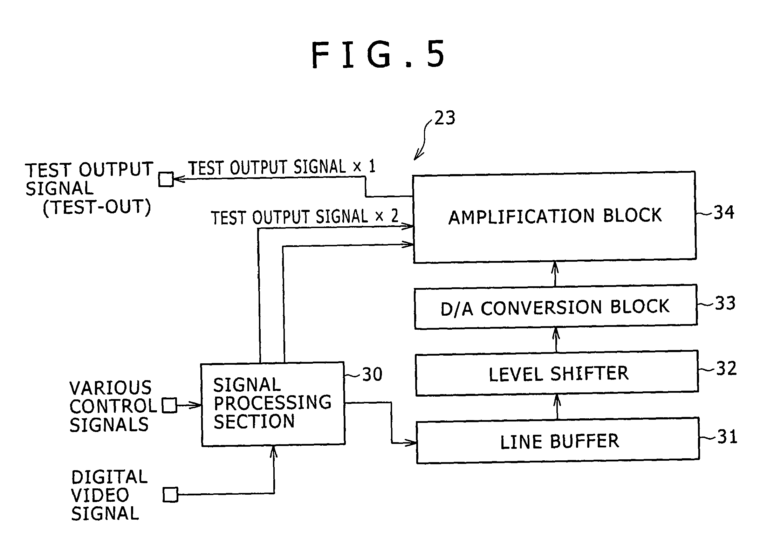

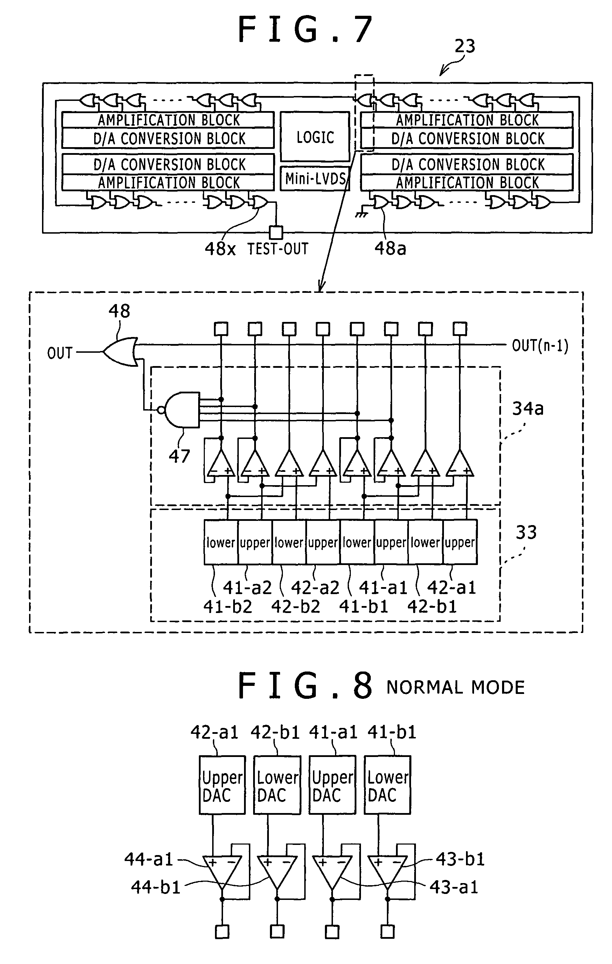

Described below is a specific example of the semiconductor integrated circuit embodying one example of the present invention, applied to a liquid crystal driver circuit (e.g., source driver circuits to be explained hereunder). A structure of a liquid crystal display apparatus incorporating the inventive liquid crystal driver circuit will be explained first, followed by the structure and operation of the liquid crystal driver circuit. FIG. 4 shows a typical structure of the liquid crystal display apparatus containing the liquid crystal driver circuit; FIGS. 5 through 7 show typical structures of the liquid crystal driver circuit; and FIGS. 8 through 11 are explanatory of operation modes of the liquid crystal driver circuit.

### [2.1 Structure of the liquid crystal display apparatus]

As shown in FIG. 4, a liquid crystal display apparatus 20 is made up of a liquid crystal panel 21, a horizontal driver circuit 22 having a plurality of source driver circuits 23 (an example of the liquid crystal driver circuit), a vertical driver circuit 24 having a plurality of gate driver circuits 25, and an interface (I/F) circuit 26.

The liquid crystal panel 21 has a semiconductor substrate furnished with transparent pixel electrodes and TFT's as well as a counter substrate constituting a single transparent electrode over an entire display section, the two substrates having a liquid crystal sealed therebetween. The TFT's each with a switching capability are controlled to apply voltages to the pixel electrodes in a manner reflecting specific levels of halftone. This generates potential differences between the pixel electrodes on the one hand and the counter substrate electrode on the other hand, in order to change the transmittance of the liquid crystal to display images.

The liquid crystal panel 21 has these pixel electrodes arrayed vertically and horizontally in a matrix pattern. On the semiconductor substrate of the liquid crystal panel 21 are a plurality of data lines which are connected to the pixel electrodes arrayed in the vertical direction and which apply graduated voltages to the pixel electrodes, and scanning lines that apply control signals for switching the TFT's.

The graduated voltages are applied to the pixel electrodes by use of drive signals output from the source driver circuits 23 over the data lines. That is, the drive signals cause the graduated voltages to be applied to all pixel electrodes connected to the data lines in a single frame period of image display. That in turn drives the pixel electrodes to display an image on the liquid crystal panel 21.

Based on signals output from the interface circuit 26, the source driver circuits 23 output drive signals onto the data lines, the drive signals being switched successively per horizontal line.

The gate driver circuits 25 output successively control signals to switch the TFT's per horizontal line. With the horizontal lines reached one by one, the image is displayed on the liquid crystal panel 21 based on the drive signals output from the source driver circuits 23.

### [2.2 Structure of the source driver circuit]

As shown in FIG. 5, the source driver circuits 23 are each made up of a signal processing section 30, a line buffer 31, a level shifter 32, a D/A (digital-to-analog) conversion block 33, and an amplification block 34.

Various control signals and a digital video signal are input to the signal processing section 30 via the interface circuit 26. In turn, the signal processing section 30 inputs pixel data reflecting the digital video signal to the line buffer 31 on a line by line basis. The signal processing section 30 also outputs diverse control signals to the amplification block 34 and to other components. Illustratively, the signal processing section 30 outputs TEST control signals to the amplification block 34 based on the control signal input via the interface circuit 26. The TEST control signals include a TEST enable signal and a TEST mode switching signal, as will be discussed later.

The line buffer 31 holds the pixel data per line (12-bit data in this case) input from the signal processing section 30. The line buffer 31 then outputs the pixel data line by line to the level shifter 32 in a suitably timed manner.

The level shifter 32 shifts the levels of the pixel data output from the line buffer 31 in a manner corresponding to the liquid crystal of the liquid crystal panel 21 and the transistor capacities of the TFT's, thereby generating digital drive signals.

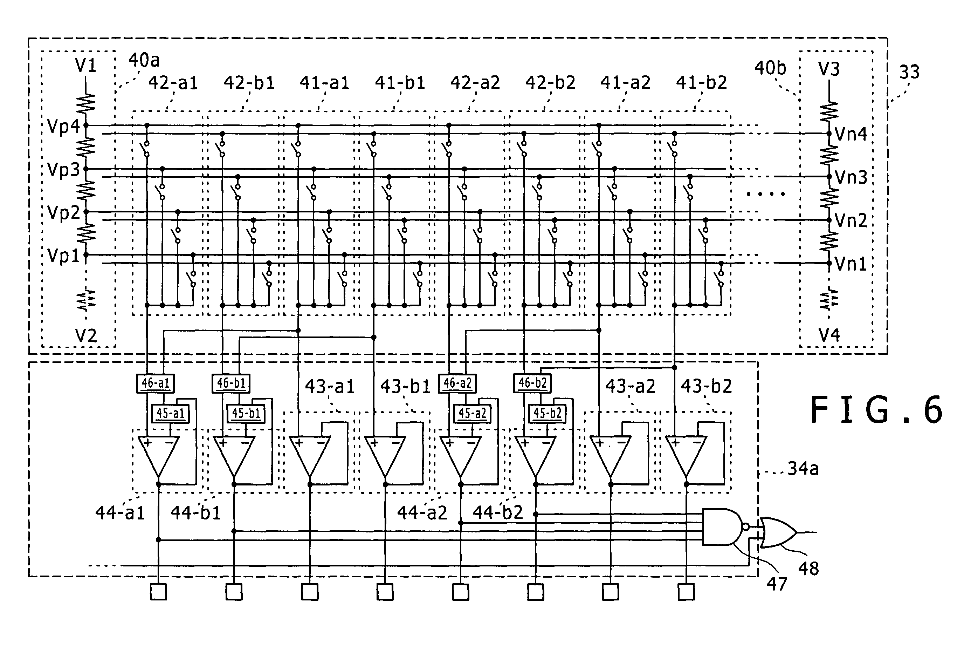

The D/A conversion block 33 includes a plurality of D/A converters 41 and 42 (see FIGS. 6 and 7, etc.) that convert the digital drive signals output from the level shifter 32 into analog drive signals. Each of the D/A converters 41 and 42 is furnished with a plurality of switches connected to the reference voltage nodes of resistance ladder circuits, as will be discussed later. These switches are controlled so as to output desired voltages.

The amplification block 34 has amplifiers corresponding to the D/A converters 41 and 42 in the D/A conversion block 33. The amplifiers current-amplify the analog drive signals output from the D/A converters 41 and 42, and output the current-amplified signals to the liquid crystal panel 21 to drive its pixels. Also, based on the TEST control signals output from the signal processing section 30, the amplification block 34 operates in the test mode to output a TEST output signal indicating whether or not the D/A converters 41 and 42 are normal.

### [2.3 Specific structures of the D/A conversion block and amplification block]

Described below are specific structures and operations of the D/A conversion block 33 and amplification block 34 which are characteristic of the source driver circuits 23 structured as discussed above.

As shown in FIGS. 6 and 7, the D/A conversion block 33 includes a first resistance ladder circuit 40a, a second resistance ladder circuit 40b, first D/A converters 41-a1, 41-b1, ..., 41-an, 41-bn; and second D/A converters 42-a1, 42-b1, ..., 42-an, 42-bn. In the ensuing description, one or all of the first D/A converters 41-a1, 41-b1, etc., may be referred to as the first D/A converter 41, and one or all of the second D/A converters 42-a1, 42-b1, etc., as the second D/A converter 42 where appropriate.

The first resistance ladder circuit 40a generates reference voltages Vp1 through Vp4 which are higher than a common voltage Vcom, and the second resistance ladder circuit 40b generates reference voltages Vn1 through Vn4 which are lower than the common voltage Vcom. For purpose of simplification and illustration, the resistance ladder circuits 40a and 40b are each assumed to have four reference voltage nodes (Vp1 through Vp4, Vn1 through Vn4). In practice, there exist voltage nodes of which the number is multiplied by the number of the bits subject to D/A conversion.

As described, the D/A conversion block 33 includes the first and the second resistance ladder circuits 40a and 40b having different voltages on their reference voltage nodes for use as the reference voltages of the first and the second D/A converters 41 and 42.

Each of the D/A converters 41 and 42 has a plurality of switches connected to the reference voltage nodes of the resistance ladder circuits. One of these switches is short-circuited to select the reference voltage node so that the voltage of the selected reference voltage node is output.

That is, the first D/A converters 41-a1, 41-a2, etc., and the second D/A converters 42-a1, 42-a2, etc., are each furnished with a plurality of switches connected to the reference voltage nodes (Vp1 through Vp4) of the resistance ladder circuit 40a, and the reference voltage of one of the nodes Vp1 through Vp4 is output. The first D/A converters 41-b1, 41-b2, etc., and the second D/A converters 42-b1, 42-b2, etc., are each provided with a plurality of switches connected to the reference voltage nodes (Vn1 through Vn4) of the resistance ladder circuit 40b, and the reference voltage of one of the nodes Vn1 through Vn4 is output.

Based on each digital drive signal output from the level shifter 32, the D/A converters 41 and 42 control their internal switches to output the voltage corresponding to the digital drive signal in question. This is how the analog drive signal is generated and output.

The amplification block 34 includes a plurality of amplifying sections 34a. Each of the amplifying sections 34a is furnished with amplifiers 43-a1, 43-a2, 43-b1 and 43-b2; operational amplifiers 44-a1, 44-2a, 44-b1 and 44-b2; first selectors 45-a1, 45-a2, 45-b1 and 45-b2; second selectors 46-a1, 46-a2, 46-b1 and 46-b2; and a NAND circuit 47.

In the ensuing description, one or all of the amplifiers 43-a1, 43-a2, 43-b1 and 43-b2 may be referred to as the amplifier 43; one or all of the operational amplifiers 44-a1, 44-2a, 44-b1 and 44-b2 as the operational amplifier 44; one or all of the first selectors 45-a1, 45-a2, 45-b1 and 45-b2 as the first selector 45; and one or all of the second selectors 46-a1, 46-a2, 46-b1 and 46-b2 as the second selector 46 where appropriate.

The amplifier 43 is composed of an operational amplifier having the noninverting input node (+) used as the input and the inverting input node (-) connected to the output node, whereby a voltage follower is constituted. As such, the amplifier 43 current-amplifies the analog drive signal output from the first D/A converter 41.

The first selector 45 connects either the output node of the operational amplifier 44 or the second selector 46 to the inverting input node (-) of the operational amplifier 44 based on the TEST enable signal output from the signal processing section 30. More specifically, when the TEST enable signal is High, the second selector 46 is connected to the inverting input node (-) of the operational amplifier 44; when the TEST enable signal is Low, the output node of the operational amplifier 44 is connected to the inverting input node (-) of the operational amplifier 44.

The second selector 46 effects switchover between the input to the noninverting input node (+) of the operational amplifier 44 and the input to the first selector 45 based on the TEST mode switching signal output from the signal processing section 30. More specifically, when the TEST mode switching signal is Low, the output of the first D/A converter 41 is connected to the inverting input node (-) of the operational amplifier 44 and the output of the second D/A converter 42 is connected to the first selector 45. When the TEST mode switching signal is High, the output of the second D/A converter 42 is connected to the inverting input node (-) of the operational amplifier 44, and the output of the first D/A converter 41 is connected to the first selector 45.

The NAND circuit 47 performs the NAND operation on the outputs of the operational amplifiers 44-a1, 44-a2, 44-b1 and 44-b2. That is, if the outputs of these operational amplifiers 44 are all High, the NAND circuit 47 outputs a Low-level signal; if any one of the outputs of the operational amplifiers 44 is Low, then the NAND circuit 47 outputs a High-level signal.

The source driver circuits 23 each include a plurality of OR circuits 48 that perform the OR operation on the outputs of the NAND circuits 47 in a plurality of amplifying sections 34a. As shown in FIG. 7, the output from one OR circuit 48 and the output from one NAND circuit 47 are input to another OR circuit 48. Following the OR operations on the outputs from all NAND circuits 47 in the plurality of amplifying sections 34a, the OR circuit 48x at the last stage outputs the result of the OR operations. Thus if any one of the NAND circuits 47 in the multiple amplifying sections 34a outputs a High-level signal, the last-stage OR circuit 48x outputs a High-level signal; otherwise the last-stage OR circuit 48x outputs a Low-level signal. One of the two input nodes of the first-stage OR circuit 48a is connected to ground potential.

### [2.4 Operations of the D/A conversion block and amplification block]

What follows is a specific explanation focused on the operations of the D/A conversion block 33 and amplification block 34 in each of the source driver circuits 23 structured as described above.

The source driver circuits 23 each operate in the normal mode based on externally input control signals. In addition to the operations in the normal mode, the source driver circuits 23 operating in the test mode can determine whether the D/A converters 41 and 42 are normal. When operating further in a first test mode and a second test mode making up the test mode, the source driver circuits 23 can determine more accurately whether the D/A converters 41 and 42 are normal.

### [2.4.1 Operations in the normal mode]

The operations in the normal mode will now be described. In the normal mode, a digital video signal reflecting the image to be displayed is input to each source driver circuit 23. Based on the input digital video signals, the signal processing section 30 inputs the pixel data of the image to be displayed, line by line, to the line buffer 31.

The line buffer 31 outputs a digital drive signal corresponding to each of the pixels of the image to be displayed on a line by line basis. The level of the output signal is adjusted by the level shifter 32, and the adjusted signal is input to the D/A conversion block 33.

The D/A conversion block 33 converts the digital drive signal corresponding to each pixel into an analog drive signal. The analog drive signal following the conversion is output to the amplification block 34.

From each first D/A converter 41, the analog drive signal is then input to each amplifier 43. The input analog drive signal is current-amplified by each amplifier 43 before being output.

At this time, a Low-level TEST enable signal and a Low-level TEST mode switching signal from the signal processing section 30 are input to the amplification block 34. In turn, the second selector 46 connects the output node of the second D/A converter 42 to the noninverting input node (+) of the operational amplifier 44, and the first selector 45 connects the output node of the operational amplifier 44 to the inverting input node (-) of the operational amplifier 44. That is, the operational amplifier 44 functions as a voltage follower that current-amplifies the output of the second D/A converter 42.

In the normal mode, the operational amplifier 44 thus constitutes a voltage follower as shown in FIG. 8, so that the analog drive signal output from the second D/A converter 42 is current-amplified by the operational amplifier 44 before being output. The analog drive signal output from the first D/A converter 41 is current-amplified by the amplifier 43 before being output.

When analog drive signals lower than the common voltage Vcom are to be output to the liquid crystal panel 21, the D/A converters 41-b1, ... 41-bn, 42-b1, ... 42-bn operate; when analog drive signals higher than the common voltage Vcom are to be output to the liquid crystal panel 21, the D/A converters 41-a1, ... 41-an, 42-a1, ... 42-an operate. Although not shown, the source driver circuits 23 are each furnished with a selector to switch between the outputs of the amplifiers 43-a1 and 43-b1, a selector to switch between the outputs of the amplifiers 43-a2 and 43-b2, a selector to switch between the outputs of the operational amplifiers 44-a1 and 44-b1, and a selector to switch between the outputs of the operational amplifiers 44-a2 and 44-b2.

### [2.4.2 Test mode]

The test mode will now be described. The test mode is made up of a first test mode and a second test mode wherein the inputs to the operational amplifiers 44 are switched by semiconductor testing equipment, not shown. The semiconductor testing equipment inputs a control signal to the input node of each source driver circuit 23 and detects the voltage output from an output node TEST-OUT, thereby determining whether the D/A conversion block 33 is normal.

The test mode is reached from the normal mode and started when the semiconductor testing equipment inputs a control signal designating the start of testing to the source driver circuits 23. When a control signal designating the end of testing is input to the source driver circuits 23, the test mode is terminated and the normal mode is reached.

When the control signal designating the start of testing is input from the semiconductor testing equipment, the signal processing section 30 supplies a High-level TEST enable signal to the amplification block 34. With the High-level TEST enable signal input to the amplification block 34, the first selector 45 disconnects the output node of the operational amplifier 44 from the inverting input node (-) and connects the inverting input node (-) to the second selector 46. This allows the operational amplifier 44 to function as a comparator that compares the output of the first D/A converter 41 with the output of the second D/A converter 42.

In response to the control signal input from the semiconductor testing equipment, the signal processing section 30 brings the TEST mode switching signal either High or Low before inputting the switching signal to the amplification block 34.

If the Low-level TEST mode switching signal is input to the amplification block 34, the second selector 46 operates in the first test mode. That is, the second selector 46 connects the output node of the second D/A converter 42 to the noninverting input node (+) of the operational amplifier 44, and the output node of the first D/A converter 41 to the inverting input node (-) of the operational amplifier 44 via the first selector 45.

If the High-level TEST mode switching signal is input to the amplification block 34, the second selector 46 operates in the second test mode. That is, the second selector 46 connects the output node of the second D/A converter 42 to the inverting input node (-) of the operational amplifier 44 via the first selector 45, and the output node of the first D/A converter 41 to the noninverting input node (+) of the operational amplifier 44.

### (First test mode)

In the first test mode, as described above, the output node of the second D/A converter 42 is connected to the noninverting input node (+) of the operational amplifier 44, and the output node of the first D/A converter 41 is connected to the inverting input node (-) of the operational amplifier 44 via the first selector 45.

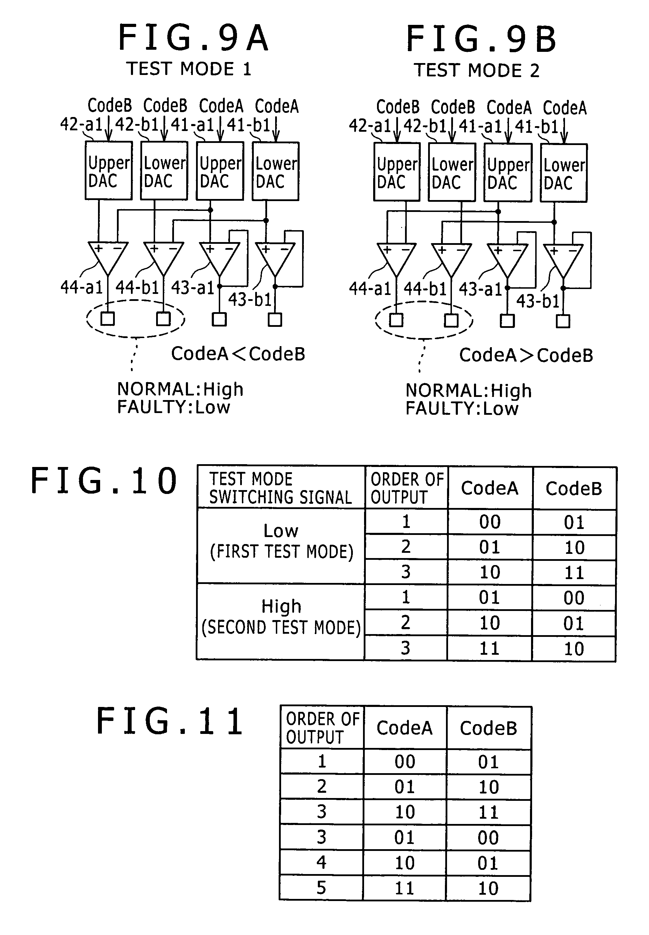

And as shown in FIG. 9A, a Code A digital drive signal is input to the first D/A converter 41. In turn, the first D/A converter 41 converts the digital drive signal into an analog drive signal that is input to the input node of the amplifier 43 and to the inverting input node (-) of the operational amplifier 44. A Code B digital drive signal is input to the second D/A converter 42. In turn, the second D/A converter 42 converts the digital drive signal into an analog drive signal that is supplied to the noninverting input node (+) of the operational amplifier 44.

In the above-described state, digital video signals are input in such a manner that the voltage level of the Code A analog drive signal will become lower than the voltage level of the Code B analog drive signal, i.e., so that Code A and Code B will be output in the order of output shown in FIG. 10. That is, the relationship of (Code A:Code B) is input successively in the order of (00:01), (01:10), (10:11). Thus when each of the D/A converters 41 and 42 is normal, the voltage level of the analog drive signal output from the first D/A converter 41 changes from Vn1 to Vn2 to Vn3, and the voltage level of the analog drive signal output from the second D/A converter 42 varies from Vn2 to Vn3 to Vn4. Because the relations of Vn1 < Vn2 < Vn3 < Vn4 hold, the operational amplifier 44 outputs the High-level voltage continuously, and the NAND circuit 47 outputs a signal indicative of normal detection. That means the output voltage of the NAND circuit 47 becomes Low.

However, if the first D/A converter 41 or the second D/A converter 42 is faulty, the output operation above is basically unavailable. The operational amplifier 44 does not output the High-level voltage continuously, and the NAND circuit 47 outputs a High-level output voltage temporarily or continuously. That is, the NAND circuit 47 outputs a signal indicative of fault detection. As a result, the voltage output from the output node TEST-OUT via the OR circuit 48x goes High temporarily or continuously.

Thus if the voltage at the output node TEST-OUT is continuously Low in the first test mode, the D/A conversion block 33 is determined to be normal; if the voltage at the output node TEST-OUT is High temporarily or continuously, then the D/A conversion block 33 is determined to be faulty.

### (Second test mode)

In the second test mode, as described above, the output node of the second D/A converter 42 is connected to the inverting input node (-) of the operational amplifier 44 via the first selector 45, and the output node of the first D/A converter 41 is connected to the noninverting input node (+) of the operational amplifier 44.

And as shown in FIG. 9B, a Code A digital drive signal is input to the first D/A converter 41. In turn, the first D/A converter 41 converts the input digital drive signal into an analog drive signal that is input to the input node of the amplifier 43 and to the noninverting input node (+) of the operational amplifier 44. A Code B digital drive signal is input to the second D/A converter 42. In turn, the second D/A converter 42 converts the input digital drive signal into an analog drive signal that is input to the inverting input node (-) of the operational amplifier 44.

In the above-described state, digital video signals are input in such a manner that the voltage level of the Code B analog drive signal will become lower than the voltage level of the Code A analog drive signal, i.e., so that Code A and Code B will be output in the order of output shown in FIG. 10. That is, the relationship of (Code A:Code B) is input successively in the order of (01:00), (10:01), (11:10). Thus when each of the D/A converters 41 and 42 is normal, the output voltage level of the first D/A converter 41 changes from Vn2 to Vn3 to Vn4, and the output voltage level of the second D/A converter 42 varies from Vn1 to Vn2 to Vn3. The operational amplifier 44 outputs the High-level voltage continuously, and the NAND circuit 47 outputs a signal indicative of normal detection. Thus the output voltage of the NAND circuit 47 becomes Low.

However, if the first D/A converter 41 or the second D/A converter 42 is faulty, the output operation above is basically unavailable. The operational amplifier 44 does not output the High-level voltage continuously, and the NAND circuit 47 outputs a High-level output voltage temporarily or continuously. That is, the NAND circuit 47 outputs a signal indicative of fault detection. As a result, the voltage output from the output node TEST-OUT via the OR circuit 48x goes High temporarily or continuously.

Thus if the voltage at the output node TEST-OUT is continuously Low in the second test mode, the D/A conversion block 33 is determined to be normal; if the voltage at the output node TEST-OUT is High temporarily or continuously, then the D/A conversion block 33 is determined to be faulty.

The second test mode helps detect a fault that cannot be detected in the first test mode. For example, if any of the switches in the second D/A converter 42 has failed and is connected continuously to the potential node of Vp4, then the output of the operational amplifier 44 is always High in the first test mode and a Low-level signal is output from the output node TEST-OUT. In the second test mode, on the other hand, the operational amplifier 44 outputs a Low-level signal temporarily or continuously, so that a High-level signal is output temporarily or continuously from the output node TEST-OUT. Likewise, it is possible to detect in the first test mode a fault that cannot be detected in the second test mode.

Thus when tests are carried out in the first and the second test modes, the detection of a faulty D/A conversion block 33 can be performed in a highly accurate manner.

In performing tests consecutively in the first test mode and second test mode, the semiconductor testing equipment finds the D/A conversion block 33 to be normal only if the voltage from the output node TEST-OUT is continuously Low; otherwise the semiconductor testing equipment determines that the D/A conversion block 33 is faulty.

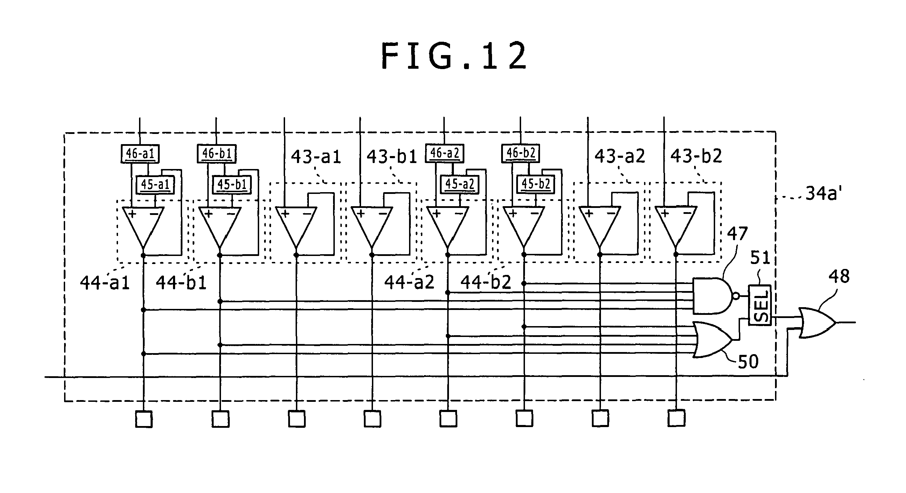

Alternatively, with either the first test mode or the second test mode discarded, testing may be carried out under the conditions of Code A > Code B and Code A < Code B, as shown in FIG. 11. As indicated in FIG. 12, this arrangement involves setting up an OR circuit 50 that performs the OR operation on the outputs of the operational amplifiers 44-a1, 44-b1, 44-a2 and 44-b2, and a third selector 51 that selectively outputs either the output of the OR circuit 50 or the output of the NAND circuit 47.

Under the condition of Code A < Code B, the third selector 51 is controlled to let the output of the NAND circuit 47 enter the OR circuit 48; when Code A > Code B, the third selector 51 is controlled to let the output of the OR circuit 50 enter the OR circuit 48. This causes the voltage at the output node TEST-OUT to be continuously Low if the D/A conversion block 33 is normal, or to be continuously High if the D/A conversion block 33 is faulty. There is thus no need to set up the second selector 46.

Although the circuit structures found in FIGS. 6 and 7 and elsewhere were shown to let the output of the operational amplifier 44 enter the NAND circuit 47 so that the Low-level output will appear at the output node TEST-OUT when the D/A conversion block 33 is normal, this is not limitative of the present invention. As an alternative, the NAND circuit 47 may be replaced by an AND circuit to let the output node TEST-OUT give a High-level output when the D/A conversion block 33 is normal. In this case, the OR circuit 48 may be replaced by an AND circuit to let the output node TEST-OUT output a High-level voltage continuously if the D/A conversion block 33 is normal, or output a Low-level voltage temporarily or continuously if the D/A conversion block 33 is faulty.

As described above, the source driver circuits 23 include as many as n first D/A converters 41 (n is an integer), n second D/A converters 42, n amplifiers 43 that amplify the outputs of the first D/A converters 41, and n operational amplifiers 44 that input the outputs of the second D/A converters 42.

Also, the source driver circuits 23 each include the first selector 45 that effects switchover between the normal mode and the test mode. The normal mode is a mode in which the operational amplifier 44 is made to function as an amplifier that amplifies the output of the second D/A converter 42 based on the control signal output from the semiconductor testing equipment. The test mode is a mode in which the operational amplifier 44 is caused to function as a comparator that compares the output of the second D/A converter 42 with the output of the first D/A converter 41.

In each of the source driver circuits 23 as part of the embodiment of the invention, the operational amplifier 44 is made to function both as an amplifier and as a comparator as described above. There is thus no need for separately installing comparators. Also, the outputs from a plurality of comparators are converged by logic circuits before being output. This makes it possible significantly to reduce the number of probes to be attached to the output nodes upon device testing while curbing the increase in the packaging area of each device. That in turn raises the number of devices that can be tested simultaneously in a single testing pass. The time required to test each device can be reduced, and testing costs can be lowered.

Each source driver circuit 23 operating in the test mode includes the second selector 46 that effects switchover between the first test mode and the second test mode. The first test mode is a mode in which the output of the first D/A converter 41 is input to the inverting input node (-) of the operational amplifier 44 while the output of the second D/A converter 42 is input to the noninverting input node (+) of the operational amplifier 44. The second test mode is a mode in which the output of the second D/A converter 42 is input to the inverting input node (-) of the operational amplifier 44 while the output of the first D/A converter 41 is input to the noninverting input node (+) of the operational amplifier 44.

The first and the second test modes established as described help the semiconductor testing equipment to carry out tests more easily. That is, the semiconductor testing equipment finds the D/A conversion block 33 to be normal only if the voltage at the output node TEST-OUT is consistently Low or High throughout both the first and the second test modes. In any other case, the semiconductor testing equipment finds the D/A conversion block 33 to be faulty.

In particular, as shown in FIG. 6 and elsewhere, the amplification block 34 is divided into a plurality of amplifying sections 34a each including a plurality of operational amplifiers 44. The outputs of the operational amplifiers 44 are input to logic circuits (e.g., NAND circuit 47) for AND or OR operations. This arrangement simplifies the structure of the logic circuitry so that any increase in the packaging area of the source driver circuits 23 can be minimized.

In the test mode, the voltages output from the D/A converters 41 and 42 are arranged to be gradually raised or lowered as discussed above. This enhances the responsiveness of the operational amplifiers 44 acting as comparators and contributes to improving the speed of testing. As a result, the testing time per device is shortened and the cost of testing can be reduced.

### [3. Other embodiments]

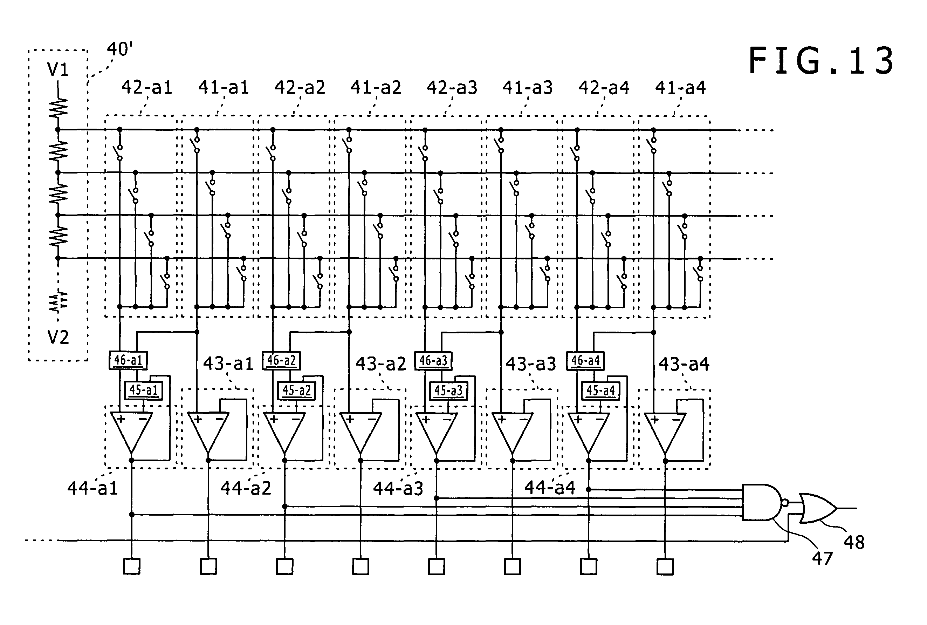

As discussed above, two types of resistance ladder circuits 40a and 40b are provided in a manner establishing the D/A converters 41a and 42a on the high-voltage side and the D/A converters 41b and 42b on the low-voltage side. However, this is not limitative of the present invention. Alternatively, as shown in FIG. 13, a resistance ladder circuit 40' may be provided in such a manner as to generate reference voltages ranging from the low-voltage side to the high-voltage side.

The embodiment above was shown to determine the D/A conversion block 33 to be normal if the voltages of the same level are output from the operational amplifiers 44 in the test mode. However, this is not limitative of the present invention. Illustratively, the inputs to adjacent operational amplifiers 44 may be alternated. If different voltages are output from the adjacent operational amplifiers 44 getting the alternate inputs, then the D/A conversion block 33 may be determined to be normal.

The present application contains subject matter related to that disclosed in Japanese Priority Patent Application JP 2009-011153 filed in the Japan Patent Office on January 21, 2009, the entire content of which is hereby incorporated by reference.

It should be understood by those skilled in the art that various modifications, combinations, subcombinations and alterations may occur depending on design requirements and other factor in so far as they are within the scope of the appended claims or the equivalents thereof.

## Claims

1. A semiconductor integrated circuit comprising:
a first digital-to-analog converter;
a second digital-to-analog converter;
an amplifier configured to amplify an output of said first digital-to-analog converter;
an operational amplifier configured to input an output of said second digital-to-analog converter; and
a selector configured to effect switchover between a normal mode and a test mode, said normal mode being a mode in which said operational amplifier is caused to function as an amplifier for amplifying the output of said second digital-to-analog converter, said test mode being a mode in which said operational amplifier is caused to function as a comparator for comparing the output of said second digital-to-analog converter with the output of said first digital-to-analog converter.

2. The semiconductor integrated circuit according to claim 1, further comprising
second selector configured to effect switchover between a first test mode and a second test mode when said test mode is in effect, said first test mode being a mode in which the output of said first digital-to-analog converter is input to a noninverting input node of said operational amplifier and the output of said second digital-to-analog converter is input to an inverting input node of said operational amplifier, said second test mode being a mode in which the output of said second digital-to-analog converter is input to said noninverting input node of said operational amplifier and the output of said first digital-to-analog converter is input to said inverting input node of said operational amplifier.

3. The semiconductor integrated circuit according to claim 1, further comprising:
n units of said first digital-to-analog converter, n being an integer of at least two;
n units of said second digital-to-analog converter;
n units of said amplifier configured to amplify the output of each unit of said first digital-to-analog converter;
n units of said operational amplifier configured to input the output of each unit of said second digital-to-analog converter; and
n units of said selector.

4. The semiconductor integrated circuit according to claim 3, further comprising
a logic circuit configured to output a signal indicative of normal detection when all outputs of said n operational amplifiers are either High or Low, and to output a signal indicative of fault detection when the output of at least one of said n operational amplifiers is either Low or High.

5. A liquid crystal driver circuit comprising:
n first digital-to-analog converters, n being an integer of at least two;
n second digital-to-analog converters;
n amplifiers each configured to amplify an output of each of said first digital-to-analog converters to supply the amplified output to a liquid crystal panel;
n operational amplifiers each configured to input an output of each of said second digital-to-analog converters; and
n selectors configured to effect switchover between a normal mode and a test mode, said normal mode being a mode in which said operational amplifiers are caused to function as amplifiers for amplifying the outputs of said second digital-to-analog converters, said test mode being a mode in which said operational amplifiers are caused to function as comparators for comparing the outputs of said second digital-to-analog converters with the outputs of said first digital-to-analog converters.

6. A liquid crystal display apparatus comprising:
a liquid crystal panel; and
a liquid crystal driver circuit configured to output drive signals for driving pixels furnished on said liquid crystal panel,
wherein said liquid crystal driver circuit includes
n first digital-to-analog converters, n being an integer of at least two,
n second digital-to-analog converters,
n amplifiers each configured to amplify an output of each of said first digital-to-analog converters to supply the amplified output to a liquid crystal panel,
n operational amplifiers each configured to input an output of each of said second digital-to-analog converters, and
n selectors configured to effect switchover between a normal mode and a test mode, said normal mode being a mode in which said operational amplifiers are caused to function as amplifiers for amplifying the outputs of said second digital-to-analog converters, said test mode being a mode in which said operational amplifiers are caused to function as comparators for comparing the outputs of said second digital-to-analog converters with the outputs of said first digital-to-analog converters.
